# EUROPÄISCHE PATENTANMELDUNG

(11) **EP 0 650 775 A1**
(43) Veröffentlichungstag der Anmeldung: **03.05.1995**
(21) Anmeldenummer: 94117007.8
(22) Anmeldetag: 27.10.1994
(51) Int. Cl.: B08B 3/04, B08B 3/08, H01L 21/00

(54) **Verfahren und Vorrichtung zur Behandlung von scheibenförmigen Werkstücken mit einer Flüssigkeit**

(30) Priorität: 27.10.1993 DE 4336704
(71) Anmelder: Wacker-Siltronic Gesellschaft für Halbleitermaterialien Aktiengesellschaft, 84489 Burghausen (DE)
(72) Erfinder: Passer, Bernd, D-84489 Burghausen (DE); Pichlmeier, Ludwig, D-84367 Reut (DE); Wengbauer, Rudolf, D-84561 Mehring (DE)
(74) Vertreter: Rimböck, Karl-Heinz, Dr.

(57) **Zusammenfassung**

Verfahren und Vorrichtung zur Behandlung von scheibenförmigen Werkstücken (4) mit einer Flüssigkeit in einer gasdicht verschließbaren Kammer (1), wobei die in einer Transporthorde (3) gestapelten Werkstücke in der geschlossenen Kammer mit der zugeführten Flüssigkeit in Kontakt gebracht werden, die Flüssigkeit aus der Kammer abgeführt wird und von der Flüssigkeit stammende schädliche Dämpfe oder Gase ausgewaschen und in gelöstem Zustand aus der Kammer abgeführt werden.

## Beschreibung

Die Erfindung betrifft ein Verfahren und eine Vorrichtung zur Behandlung von scheibenförmigen Werkstücken mit einer Flüssigkeit in einer gasdicht verschließbaren Kammer.

Als Werkstücke kommen vor allem Halbleiterscheiben in Frage. Es ist jedoch auch nicht ausgeschlossen, andere scheibenförmige Werkstücke, beispielsweise optische oder magnetische Disks oder Scheiben aus Glas in der erfindungsgemäßen Vorrichtung nach dem erfindungsgemäßen Verfahren zu behandeln.

Aus der internationalen Patentanmeldung WO-92/21142 sind ein Verfahren und eine Vorrichtung zum Reinigen von Halbleiterscheiben bekannt. Die Vorrichtung besteht aus einem zylinderförmigen Reaktor. Zum Beladen des Reaktors müssen die Halbleiterscheiben aus Transporthorden gehoben und an Halteelemente im Inneren des Reaktors übergeben werden. Während der Reinigung führen die Halbleiterscheiben im geschlossenen Reaktor Rotationsbewegungen durch. Die gereinigten Halbleiterscheiben müssen anschließend in die Transporthorden zurückgehoben werden. Sowohl beim Be- und Entladen, als auch während der Reinigung sind die Halbleiterscheiben in unmittelbarer Nähe mechanisch bewegter Vorrichtungsteile. Es besteht die Gefahr, daß dadurch die Halbleiterscheiben kontaminiert und/oder beschädigt werden.

Die Flüssigkeiten, die zur Behandlung von scheibenförmigen Werkstücken verwendet werden, sind häufig Quellen schädlicher Dämpfe oder Gase. Dämpfe oder Gase werden im Sinne der Erfindung als schädlich angesehen, wenn die in ihnen enthaltenen Wirkstoffe in Verdacht stehen, gesundheitsschädlich zu sein oder nachgewiesenermaßen gesundheitsschädlich sind. Üblicherweise müssen die sich während der Behandlung der Werkstücke entwickelnden schädlichen Dämpfe oder Gase mit Hilfe von Abgasleitungen aus der Vorrichtung, in der die Behandlung stattfindet entfernt und beispielsweise in externen Gaswäschern unschädlich gemacht werden. Dies erfordert hohe Investitionskosten und schränkt die Flexibilität bei der Wahl des Standorts der Vorrichtung erheblich ein, da die Installation nur dort möglich ist, wo die Peripherie für die Gaswäsche vorhanden ist.

Hinsichtlich der Vermeidung der Emission schädlicher Dämpfe oder Gase aus einer wie auch immer gearteten Vorrichtung zur Behandlung von scheibenförmigen Werkstücken mit einer Flüssigkeit sind aus dem Stand der Technik keine befriedigenden Lösungsvorschläge bekannt geworden.

Die Aufgabe der Erfindung bestand deshalb darin, ein Verfahren und eine Vorrichtung zur Behandlung von scheibenförmigen Werkstücken mit einer Flüssigkeit zu entwickeln, wobei die Werkstücke weder aus Transporthorden genommen noch während der Behandlung bewegt werden müssen. Ferner bestand die Aufgabe darin, die Emission schädlicher Dämpfe oder Gase aus der Vorrichtung wirksam zu verhindern.

Gelöst wird die Aufgabe durch ein Verfahren zur Behandlung von scheibenförmigen Werkstücken mit einer Flüssigkeit in einer gasdicht verschließbaren Kammer, das dadurch gekennzeichnet ist, daß die in einer Transporthorde gestapelten Werkstücke in der geschlossenen Kammer mit der zugeführten Flüssigkeit in Kontakt gebracht werden, die Flüssigkeit aus der Kammer abgeführt wird und von der Flüssigkeit stammende schädliche Dämpfe oder Gase ausgewaschen und in gelöstem Zustand aus der Kammer abgeführt werden. Ferner wird die Aufgabe durch eine Vorrichtung gemäß dem unabhängigen Vorrichtungsanspruch gelöst.

Beispiele für Flüssigkeiten, die schädliche Dämpfe oder Gase entwickeln können, sind Ameisensäure, Flußsäure, Salpetersäure, Ammoniak und Kalilauge, wobei die genannten Verbindungen konzentriert oder als verdünnte wässerige Lösungen vorliegen können, Gemische der genannten Verbindungen und organische Lösemittel.

Beispiele für die Behandlung mit einer Flüssigkeit, während der schädliche Dämpfe oder Gase entstehen können, sind das Entkitten, Reinigen, Ätzen, Beschichten und die Hydrophilierung von Halbleiterscheiben.

Während des erfindungsgemäßen Verfahrens sind die scheibenförmigen Werkstücke in sogenannten Horden, die zum Transport der Werkstücke benutzt werden, gestapelt. Das Herausheben der Werkstücke aus den Transporthorden oder ein Umbetten der Werkstücke in andere Trägerkörper unmittelbar vor oder nach der Behandlung ist nicht vorgesehen. Zunächst werden eine oder mehrere mit Werkstücken beladene Transporthorden in eine gasdicht verschließbare Kammer eingebracht und die Kammer verschlossen. Anschließend wird die zur Behandlung der Werkstücke vorgesehene Flüssigkeit in die Kammer zugeführt. Vorzugsweise wird dabei soviel Flüssigkeit in die Kammer gepumpt, daß der sich ausbildende Flüssigkeitsspiegel die Werkstücke vollkommen überdeckt. Nach einer bestimmten, von der Flüssigkeit abhängigen Einwirkzeit, wird die Flüssigkeit wieder aus der Kammer abgepumpt oder abgelassen.

Im Fall, daß sich während der Behandlung der Werkstücke mit der Flüssigkeit schädliche Dämpfe oder Gase gebildet haben, die nach dem Abführen der Flüssigkeit in der Kammer verblieben sind, ist vorgesehen, diese Dämpfe oder Gase zunächst auszuwaschen und in gelöstem Zustand aus der Kammer zu entfernen. Wasserlösliche Dämpfe oder Gase werden vorzugsweise mit Wasser oder wässerigen Lösungen ausgewaschen und das resultierende Abwasser wird aus der Kammer in einen Abwasserbehälter abgeführt. Dämpfe oder Gase organischen Ursprungs, die sich in Wasser nicht oder nur schlecht lösen, werden zweckmäßigerweise mit einem organischen Lösemittel ausgewaschen und in flüssiger organische Phase gelöst aus der Kammer in einen Entsorgungsbehälter abgeführt.

Vorzugsweise wird das zum Auswaschen der Dämpfe oder Gase vorgesehne Medium in der Kammer versprüht, um die bei der Absorption wirksame Oberfläche zu erhöhen. Nötigenfalls wird das Auswaschen schädlicher Dämpfe oder Gase einmal oder mehrmals wiederholt. In der Regel ist es jedoch ausreichend, ein einziges Mal solange Medium einzusprühen, bis die Kammer geflutet ist und dann die Kammer zu entleeren.

Im Anschluß an das Auswaschen schädlicher Dämpfe oder Gase und nach dem Entleeren der Kammer kann die Behandlung der Werkstücke mit der gleichen oder einer anderen Flüssigkeit analog der beschriebenen Vorgehensweise fortgesetzt werden. Im Bedarfsfall können so mehrere aufeinanderfolgende Behandlungen durchgeführt werden, wobei die in der Transporthorde gestapelten Werkstücke in der geschlossenen Kammer bleiben.

Einen Sonderfall der Behandlung der Werkstücke mit einer Flüssigkeit stellt die Trocknung der Werkstücke unter Verwendung von heißem Wasser dar. Zunächst wird heißes Wasser mit einer Temperatur von 85 bis 95 °C in die Kammer zugeführt, bis die Werkstücke vollständig darin eintauchen. Anschließend wird das heiße Wasser langsam aus der Kammer wieder entfernt, beispielsweise indem man es abpumpt oder ablaufen läßt. Dabei trocknen die Werkstücke an der Phasengrenze des ablaufenden Wassers, ohne dabei bewegt werden zu müssen und ohne daß ein trocknender Gasstrom zugeführt werden muß.

Wenn die Behandlung der Werkstücke mit der Flüssigkeit abgeschlossen ist und gegebenenfalls entstandene schädliche Dämpfe oder Gase ausgewaschen und aus der Kammer abgeführt worden sind, kann die Kammer geöffnet werden. Die Werkstücke stehen daraufhin, da sie in standardisierten Transporthorden gestapelt sind, ohne weitere Umlagerungsmaßnahmen einem anschließenden Weiterverarbeitungsprogramm zur Verfügung.

Im folgenden wird an Hand einer Figur eine Vorrichtung beschrieben, mit der das erfindungsgemäße Verfahren durchgeführt werden kann. Bei der schematisch gezeigten Vorrichtung handelt es sich beispielhaft um eine mögliche Ausführungsform.

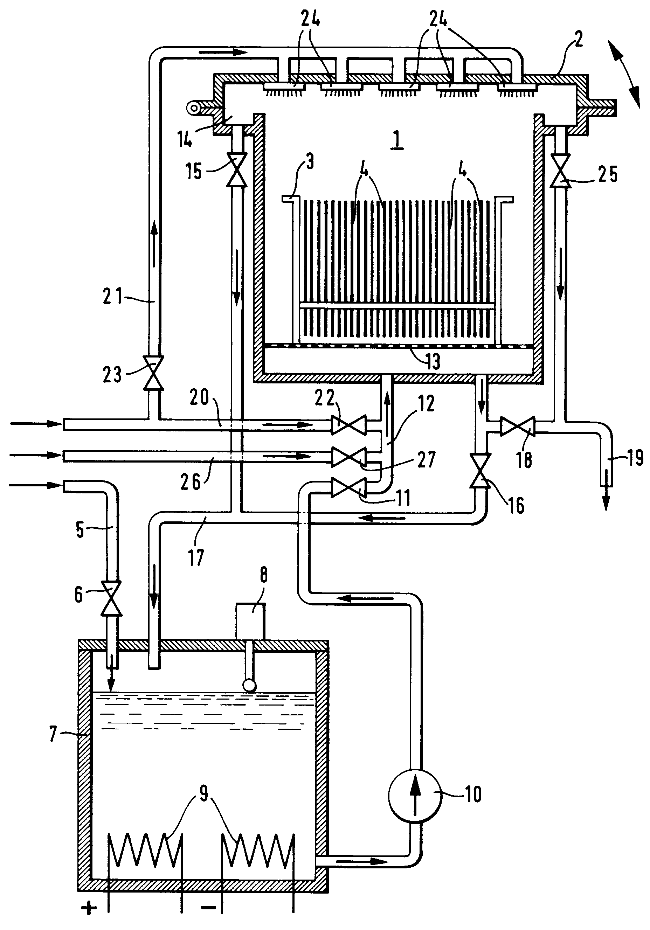

Die Vorrichtung zur Behandlung von scheibenförmigen Werkstücken mit einer Flüssigkeit besteht im wesentlichen aus einer Kammer 1, die mit einem Deckel 2 gasdicht verschlossen werden kann. Die in einer oder mehreren der üblichen Transporthorden 3 gestapelten Werkstücke 4 befinden sich zur Behandlung mit der Flüssigkeit in der geschlossenen Kammer. Die Kammer ist an mehrere Zu- und Ablaufleitungen angeschlossen. Ihre Gesamtzahl ist dadurch bestimmt, wieviele verschiedene Flüssigkeiten in aufeinander folgenden Behandlungen auf die Werkstücke einwirken sollen. Bei der vorliegenden Ausführungsform wird angenommen, daß neben heißem Wasser zur Trocknung und kaltem Wasser zum Auswaschen schädlicher Dämpfe oder Gase nur eine Flüssigkeit zum Behandeln der Werkstücke bereitgestellt werden muß. Diese Flüssigkeit wird über die Versorgungsleitung 5 und das Zulaufventil 6 dem Vorlagebehälter 7 zugeführt. Der Vorlagebehälter ist mit einer Füllstandsregelung 8 und einer kombinierten Kühl- und Heizvorrichtung 9 ausgestattet, so daß die Flüssigkeit zur Behandlung der Werkstücke bei Bedarf thermostatisiert werden kann. Mit Hilfe der Pumpe 10 kann die Flüssigkeit aus dem Vorlagebehälter 7 durch das Zulaufventil 11 und die Zuflaufleitung 12 der Kammer 1 zugeführt und über einen Lochboden 13 verteilt werden. Ein Überlauf 14 sorgt bei geöffnetem Überlaufventil 15 dafür, daß die Flüssigkeit, wenn ein entsprechender Füllstand in der Kammer erreicht ist, in den Vorlagebehälter zurück transportiert wird. Auf diese Weise kann der ständige Austausch von Flüssigkeit in der Kammer und im Vorlagebehälter während der Behandlung der Werkstücke gewährleistet werden. Das Rücklaufventil 16 und die Rücklaufleitung 17 sind vorgesehen, um die Flüssigkeit nach der Behandlung der Werkstücke aus der Kammer zurück in den Vorlagebehälter zu führen. Darüber hinaus kann über das Ablaufventil 18 und die Ablaufleitung 19 die Flüssigkeit bei Bedarf in einen in der Figur nicht gezeigten Entsorgungsbehälter überführt werden.

Während der Behandlung entstandene schädliche Dämpfe oder Gase werden gemäß der gezeigten Ausführungsform dadurch ausgewaschen, daß kaltes Wasser in die Kammer zugeführt wird. Dazu stehen die Zulaufleitungen 20 und 21 zur Verfügung. Über das Zulaufventil 22 kann kaltes Wasser der Kammer direkt zugeführt werden, über das Zulaufventil 23 geschieht dies über Sprühdüsen 24. Der Zulauf von kaltem Wasser in die Kammer kann gleichzeitig direkt und über die Sprühdüsen erfolgen, oder nur über die Sprühdüsen. Ein weiteres Überlaufventil 25 gestattet das Abführen der ausgewaschenen Dämpfe oder Gase die Ablaufleitung 19 in einen in der Figur nicht gezeigten Abwasserbehälter. Alternativ können dafür das Ablaufventil 18 und die Ablaufleitung 19 benutzt werden.

Zur Trocknung der Werkstücke durch eine Behandlung unter Verwendung von heißem Wasser wird dieses durch die Zulaufleitung 26 und das Zulaufventil 27 direkt in die Kammer zugeführt. Zur erforderlichen Aufheizung der Werkstücke wird die Zuführung des heißen Wassers bis zur Erreichung einer Zieltemperatur fortgesetzt. Überschüssiges Wasser wird über das Überlaufventil 25 und die Ablaufleitung 19 in einen in der Figur nicht gezeigten Abwasserbehälter abgeführt. Entsprechend stehen das Ablaufventil 18 und die Ablaufleitung 19 zur Verfügung, um anschließend das heiße Wasser in einer den Trocknungsprozeß der Werkstücke bestimmenden Geschwindigkeit aus der Kammer wieder abzuführen.

Soweit es vorstehend nicht explizit erwähnt ist, sind die genannten Zu- oder Ablaufleitungen mit in der Figur nicht gezeigten Reservoirs verbunden, in denen die jeweiligen Medien bereitgestellt oder entsorgt werden. Der Transport der Medien erfolgt zweckmäßigerweise über in der Figur ebenfalls nicht gezeigte Förderpumpen.

Vorzugsweise werden alle mit der Flüssigkeit in Berührung kommenden Vorrichtungsteile aus Kunststoff gefertigt. Dies gilt insbesondere für die Innenwände der Kammer und des Vorlagebehälters sowie die Innenwände der sie verbindenden Zuund Ablaufleitungen.

Die vorgestellte Vorrichtung verfügt über ein hohes Automatisierungspotential. Sind weitere Vorlagebehälter angeschlossen, können die Werkstücke in aufeinander folgenden Schritten mit mehreren Flüssigkeiten behandelt werden, ohne daß die Vorrichtung zwischenzeitlich geöffnet und die Werkstücke bewegt werden müssen. Auch während der Behandlung mit einer Flüssigkeit werden die Werkstücke nicht bewegt und stehen nicht in unmittelbarer Nähe zu bewegten Vorrichtungsteilen. Durch die integrierte Möglichkeit, schädliche Dämpfe oder Gase auszuwaschen, ist die Vorrichtung dezentral und ortsunabhängig einsetzbar. Ein Ortswechsel ist jederzeit problemlos möglich.

## Patentansprüche

1. Verfahren zur Behandlung von scheibenförmigen Werkstücken mit einer Flüssigkeit in einer gasdicht verschließbaren Kammer, dadurch gekennzeichnet, daß
die in einer Transporthorde gestapelten Werkstücke in der geschlossenen Kammer mit der zugeführten Flüssigkeit in Kontakt gebracht werden, die Flüssigkeit aus der Kammer abgeführt wird und von der Flüssigkeit stammende schädliche Dämpfe oder Gase ausgewaschen und in gelöstem Zustand aus der Kammer abgeführt werden.

2. Verfahren nach Anspruch 1, dadurch gekennzeichnet, daß
wasserlösliche Dämpfe oder Gase mit Wasser oder wässerigen Lösungen ausgewaschen werden.

3. Verfahren nach Anspruch 1, dadurch gekennzeichnet, daß
in Wasser schwerlösliche oder in Wasser unlösliche Dämpfe oder Gase mit einem organischen Lösemittel ausgewaschen werden.

4. Verfahren nach Anspruch 1, dadurch gekennzeichnet, daß
die Behandlung der Werkstücke mit heißem Wasser zum Trocknen der Werkstücke durchgeführt wird.

5. Verfahren nach einem der Ansprüche 1 bis 3, dadurch gekennzeichnet, daß
die Behandlung der Werkstücke fortgesetzt wird, indem die Werkstücke mit der gleichen oder einer davon verschiedenen Flüssigkeit in Kontakt gebracht werden.

6. Vorrichtung zur Behandlung von scheibenförmigen Werkstücken mit einer Flüssigkeit, gekennzeichnet durch
eine gasdicht verschließbare Kammer zur Aufnahme der in einer Transporthorde gestapelten Werkstücke, einen Vorlagebehälter zur Aufnahme der Flüssigkeit, Mitteln zum Zuführen der Flüssigkeit aus dem Vorlagebehälter in die verschließbare Kammer, Mitteln zum Abführen der Flüssigkeit aus der verschließbaren Kammer in den Vorlagebehälter, Mitteln zum Thermostatisieren der in die verschließbare Kammer zugeführten Flüssigkeit und Mitteln zum Auswaschen von schädlichen Dämpfen oder Gasen, die von der Flüssigkeit stammen.

7. Vorrichtung nach Anspruch 6, gekennzeichnet durch
einen oder mehrere weitere Vorlagebehälter zur Aufnahme einer oder mehrerer weiterer Flüssigkeiten, Mittel zum Zuführen der weiteren Flüssigkeit(en) aus dem (den) weiteren Vorlagebehälter(n) in die verschließbare Kammer, Mittel zum Abführen der weiteren Flüssigkeit(en) aus der verschließbaren Kammer in den (die) weiteren Vorlagebehälter und Mittel zum Thermostatisieren der in die verschließbare Kammer zugeführten weiteren Flüssigkeit(en).

8. Vorrichtung nach Anspruch 6 oder 7, gekennzeichnet durch
Sprühdüsen als Mittel zum Auswaschen von schädlichen Dämpfen oder Gasen.
